# EUROPEAN PATENT SPECIFICATION

(11) **EP 3 422 402 B1**
(45) Date of publication and mention of the grant of the patent: **27.01.2021**
(21) Application number: 18180529.2
(22) Date of filing: 28.06.2018
(51) Int. Cl.: H01L 23/40, H01L 23/473, H05K 7/20, F25B 31/00, F24F 1/24, F28D 21/00, F28F 1/22

(54) **COMPOSITE PIPE AND REFRIGERATING APPARATUS**
VERBUNDROHR UND KÜHLVORRICHTUNG
TUYAU COMPOSITE ET APPAREIL RÉFRIGÉRANT

(30) Priority: 30.06.2017 JP 2017129698
(43) Date of publication of application: 02.01.2019
(73) Proprietor: MITSUBISHI HEAVY INDUSTRIES THERMAL SYSTEMS, LTD., Tokyo 108-8215 (JP)
(72) Inventor: KUGA, Yuki, Tokyo 108-8215 (JP); SUMIYA, Atsuyuki, Tokyo 108-8215 (JP); HIROSE, Masaki, Tokyo 108-8215 (JP); ONO, Kenzo, Tokyo 108-8215 (JP)
(74) Representative: Cabinet Beau de Loménie

(56) References cited:
- EP-A1- 3 421 905
- EP-A2- 2 848 877
- CN-A- 104 650 817
- CN-U- 202 750 393
- JP-A- 2010 114 121
- JP-A- 2015 233 074
- JP-B2- 4 973 702

## Description

### BACKGROUND OF THE INVENTION

### Field of the Invention

The present invention relates to a composite pipe and a refrigerating apparatus.

### Description of Related Art

In a refrigerating apparatus, cooling of heat generating parts of a board unit by mounting a cooling jacket that supports a copper pipe through which a refrigerant is allowed to flow on the heat generating parts is known. In such a refrigerating apparatus, reduction of thermal resistance between the cooling jacket and a pipe is performed by interposing a heat transfer sheet between the cooling jacket and the pipe (JP2015233074A).

JP2015233074A discloses a refrigerating apparatus including a cooling pipe, a cooling jacket having a curved section configured to accommodate half of the cooling pipe, and a heat transfer sheet installed between an outer circumferential surface of the cooling pipe and a curved surface of the curved section.JP4976702B discloses a method of connecting an electrical component module and cooling member, and air conditioning device. JP4973702B discloses a composite pipe, comprising a refrigerant pipe, a plate-shaped member, a bonding section, a cooling member and a member installed between the plate-shaped member and the cooling member. JP2010114121A discloses a heat radiator of an electrical component.

A metal that is a material of the cooling pipe may be a different kind of metal from a metal that is a material of the cooling jacket.

### SUMMARY OF THE INVENTION

However, in the refrigerating apparatus disclosed in JP Publication No. 2015-233074, since the heat transfer sheet is installed on the curved section, adhesiveness of the heat transfer sheet to the cooling pipe and the curved section may deteriorate.

In this way, if the adhesiveness of the heat transfer sheet to the cooling section may deteriorate.

In this way, if the adhesiveness of the heat transfer sheet to the cooling pipe and the curved section decreases, the cooling pipe and the cooling jacket may come in direct contact with each other.

Then, when the material of the cooling pipe and the material of the cooling jacket are dissimilar metals, since ionization tendencies of these metals are different, interface corrosion due to bonding of the dissimilar metals may occur.

Here, the present invention is directed to providing a composite pipe and a refrigerating apparatus that are capable of suppressing interface corrosion due to contact between dissimilar metals.

In order to solve the problems, a composite pipe according to an aspect of the present invention includes: a refrigerant pipe formed of a metal and through which a refrigerant is allowed to flow; a plate-shaped member formed of the same metal of the refrigerant pipe and having a first side plane in contact with an outer circumferential surface of the refrigerant pipe and a second side plane opposite to the first side plane; a bonding section installed between the first side plane of the plate-shaped member and the outer circumferential surface of the refrigerant pipe so as to join the refrigerant pipe with the plate-shaped member; a cooling member configured to cool heat generating parts via the plate-shaped member by the refrigerant flowing through the refrigerant pipe, which is formed of a different metal from the refrigerant pipe and the plate-shaped member, and has a first surface facing the second side plane of the plate-shaped member and a second surface opposite to the first surface and in contact with the heat generating parts; and a sheet-shaped heat transfer member installed between the plate-shaped member and the cooling member so as to be adhered to the second side plane of the plate-shaped member and the first surface of the cooling member.

According to the present invention, since the plate-shaped member and the sheet-shaped heat transfer member are interposed between the cooling member and the refrigerant pipe formed of the different metal from the refrigerant pipe, direct contact between the cooling member and the refrigerant pipe can be minimized. Accordingly, interface corrosion due to contact between the cooling member and the refrigerant pipe that are formed of dissimilar metals can be minimized.

Also, since the sheet-shaped heat transfer member is interposed between the plate-shaped member and the cooling member that are formed of the same metal as the refrigerant pipe, direct contact between the plate-shaped member and the cooling member that are formed of dissimilar metals can be minimized. Accordingly, interface corrosion on an interface between the plate-shaped member and the cooling member can be minimized.

In addition, since a surface of the plate-shaped member adhered to the sheet-shaped heat transfer member (the other plane) and a surface of the cooling member (the one plane) are planes, adhesiveness between the other plane of the plate-shaped member, the plane of the cooling member and the sheet-shaped heat transfer member can be improved. Accordingly, since direct contact between the cooling member and the refrigerant pipe can be further minimized, interface corrosion due to contact between the cooling member and the refrigerant pipe can be further minimized.

In the composite pipe according to an aspect of the present invention, the sheet-shaped heat transfer member may be a heat conductive sheet or a heat conductive phase change sheet.

The heat conductive sheet or the heat conductive phase change sheet can be used as the sheet-shaped heat transfer member. In particular, since the heat conductive phase change sheet is softened by heat, heat conductivity between the plate-shaped member and the cooling member can be increased.

In addition, since the heat conductive sheet or the heat conductive phase change sheet is used, occurrence of thickness non-uniformity that occurs when a silicone grease is used can be minimized.

In the composite pipe according to an aspect of the present invention, it may be such that an outline of one of the second side plane of the plate-shaped member and the first surface of the cooling member is smaller than that of the other, and the sheet-shaped heat transfer member is in contact with the one of the second side plane of the plate-shaped member and the first surface of the cooling member such that a circumferential edge of the sheet-shaped heat transfer member extends beyond the outline of the one.

As the above-mentioned configuration is provided, direct contact between the cooling member and the refrigerant pipe can be further minimized.

A refrigerating apparatus according to an aspect of the present invention may include: the above mentioned composite pipe; and a circuit board provided with a circuit board main body whose circuit pattern is formed on one surface of the circuit main body and the heat generating parts being mounted on the circuit pattern, wherein the heat generating parts are in contact with the second surface of the cooling member.

According to the refrigerating apparatus configured as described above, the heat generating parts can be sufficiently cooled while minimizing interface corrosion due to contact between the cooling member and the refrigerant pipe.

According to the present invention, interface corrosion due to contact between dissimilar metals can be minimized.

### BRIEF DESCRIPTION OF THE DRAWINGS

FIG. 1 is a view schematically showing a schematic configuration of a refrigerating apparatus according to an embodiment of the present invention.
FIG. 2 is an exploded perspective view showing a board accommodating section on which a controller shown in FIG. 1 is installed, and a refrigerant pipe.
FIG. 3 is a cross-sectional view of a structure in an A₁-A₂ line direction shown in FIG. 2.
FIG. 4 is an enlarged cross-sectional view of a major part of the structure in a state in which the structure shown in FIG. 3 is assembled.
FIG. 5 is a cross-sectional view in which a circuit board, heat generating parts and a composite pipe, shown in FIG. 4, are simplified.
FIG. 6 is a view showing a plate-shaped member, a sheet-shaped heat transfer member and a cooling member shown in FIG. 5 from an arrow B.
FIG. 7 is a cross-sectional view for explaining a composite pipe according to a variant of the embodiment.
FIG. 8 is a view showing a plate-shaped member, a sheet-shaped heat transfer member and a cooling member shown in FIG. 7 from an arrow C.

### DETAILED DESCRIPTION OF THE INVENTION

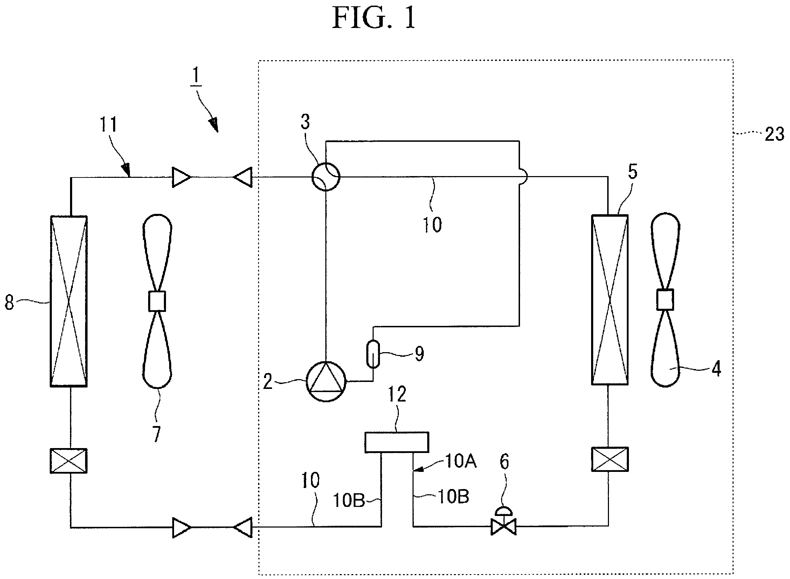

Referring to FIGS. 1 to 3, a refrigerating apparatus 1 of an embodiment will be described. In FIG. 1, an air conditioner is exemplarily shown as an example of the refrigerating apparatus 1. In the structures shown in FIGS. 1 to 3, the same reference numerals designate the same components.

The refrigerating apparatus (the air conditioner) 1 has a refrigerating cycle 11, a controller 12, a board accommodating section 14 and a housing 23.

The refrigerating cycle 11 has a compressor 2, a four-way switching valve 3, an outdoor fan 4, an outdoor heat exchanger 5, an electronic expansion valve (EEV) 6, an indoor fan 7, an indoor heat exchanger 8, an accumulator 9 and a refrigerant pipe 10.

The refrigerating cycle 11 constitutes a closed cycle by connecting the compressor 2, the four-way switching valve 3, the outdoor fan 4, the outdoor heat exchanger 5, the electronic expansion valve 6, the indoor fan 7, the indoor heat exchanger 8 and the accumulator 9 using the refrigerant pipe 10.

The compressor 2, the four-way switching valve 3, the outdoor fan 4, the outdoor heat exchanger 5, the electronic expansion valve 6 and the accumulator 9 are accommodated in the housing 23 of outdoor equipment. The indoor fan 7 and the indoor heat exchanger 8 are accommodated in a housing (not shown) of indoor equipment.

The compressor 2 compresses a refrigerant flowing through the refrigerant pipe 10. The four-way switching valve 3 switches a circulating direction of the refrigerant.

The outdoor heat exchanger 5 exchanges heat between the refrigerant flowing through the refrigerant pipe 10 and external air from the outdoor fan 4. The electronic expansion valve 6 adiabatically expands the refrigerant flowing through the refrigerant pipe 10.

The indoor heat exchanger 8 exchanges heat between the refrigerant flowing through the refrigerant pipe 10 and indoor air from the indoor fan 7.

The accumulator 9 separates a liquid phase of the refrigerant that cannot be evaporated by an evaporator, and suppresses the liquid phase from flowing into the compressor 2.

The board accommodating section 14 is accommodated in the housing 23. The controller 12 is attached to the board accommodating section 14.

The board accommodating section 14 is disposed in the housing 23 of the outdoor equipment at an interval with an inner surface of a near side and an inner surface of a back side of the housing 23. Here, "the near side" is referred to as a front surface side when the outdoor equipment is installed, and "the back side" is referred to as a rear surface side when the outdoor equipment is installed.

The controller 12 controls an operation of the refrigerating apparatus 1 on the basis of an operation order from an operation unit such as a remote controller or the like. The controller 12 is accommodated in the housing 23 of the outdoor equipment.

For example, the controller 12 switches the four-way switching valve 3 according to the operation mode and further controls rotational speeds of the outdoor fan 4 and the indoor fan 7, an opening angle of the electronic expansion valve 6, and so on, while mounting an inverter configured to control a rotational speed of the compressor 2.

The controller 12 has a circuit board 21 attached to the board accommodating section 14, and various electronic parts including heat generating parts 25A and 25B.

The circuit board 21 has a plate-shaped circuit board main body formed of an insulating material, and circuit patterns formed on one surface and the other surface of the circuit board main body.

The circuit board 21 has a front surface 21a (a surface of the circuit board main body disposed on the side of the other surface), and a rear surface 21b (a surface of the circuit board main body disposed on the side of the one surface).

The circuit board 21 may have an attachment/detachment through-hole 27 configured to attach and detach a block attachment/detachment screw 31 to/from a portion opposite to a block attachment/detachment screw 31, which will be described below.

Further, in the embodiment, the front surface 21a of the circuit board 21 is disposed toward the near side, and the rear surface 21b of the circuit board 21 is disposed toward the back side.

For example, an active converter, a diode module, a power transistor, and so on, which constitute an inverter, may be exemplified as the various electronic parts.

Some of the various electronic parts are mounted in a circuit pattern (the front surface 21a of the circuit board 21) formed on the other surface of the circuit board main body.

The heat generating part 25A comes in contact with a plane 26d2 of a second block 26b, which will be described below. The heat generating part 25B comes in contact with a plane 26d1 of the second block 26b, which will be described below.

The heat generating parts 25A and 25B each include lead frames. The lead frames of the heat generating parts 25A and 25B are electrically connected to the circuit pattern (the rear surface 21b of the circuit board 21) formed on the other surface of the circuit board main body.

Accordingly, the heat generating parts 25A and 25B are electrically connected to the circuit board 21. For example, power devices may be exemplified as the heat generating parts 25A and 25B.

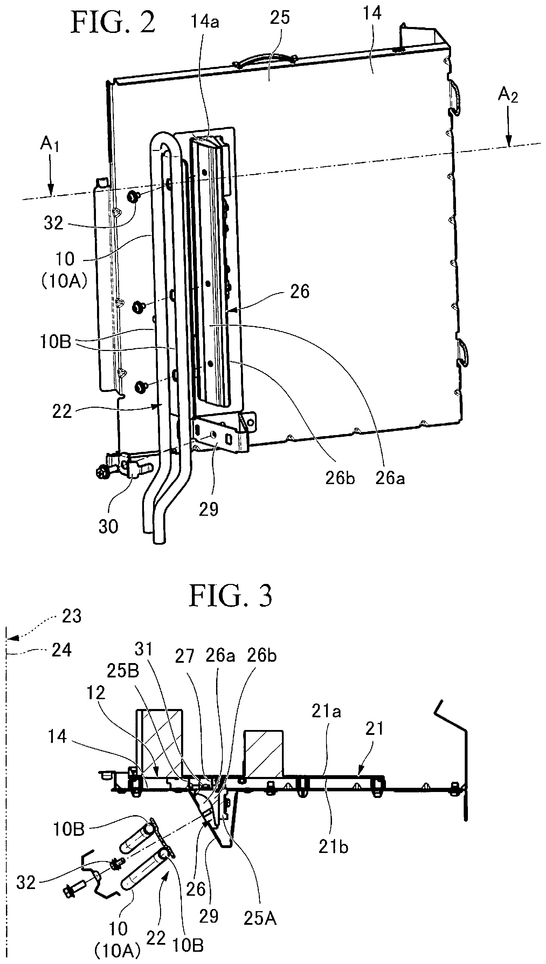

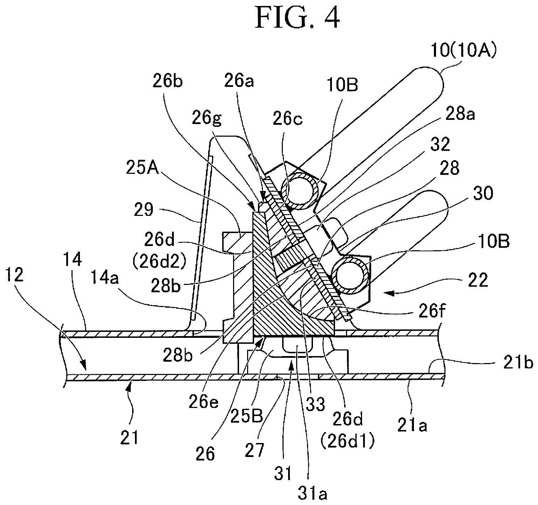

Next, referring to FIGS. 2 to 4, the refrigerant pipe 10 will be described. In FIG. 4, the same components as in the structures shown in FIGS. 2 and 3 are designated by the same reference numerals.

The refrigerant pipe 10 has an area 10A formed between the electronic expansion valve 6 and the indoor heat exchanger 8. The area 10A is disposed at the rear surface 21b side of the circuit board 21 on the back side of the board accommodating section 14 in the housing 23.

In the area 10A, a pair of tubular sections 10B are formed from the refrigerant pipe 10 formed in a U shape. Accordingly, the refrigerant pipe 10 has the pair of tubular sections 10B.

The pair of tubular sections 10B are disposed parallel to an inclined direction with respect to a backward direction of the housing 23 (a direction from the near side toward the back side). More specifically, with respect to one of the tubular sections 10B, the other of the tubular sections 10B is disposed on the back side in the housing 23, and disposed on a side of a side surface 24 that is an end surface of the housing 23 in the widthwise direction.

The refrigerant pipe 10 configured as described above is formed of a metal (a metal material) different from a metal (a metal material) of a cooling member 26 (to be described below). For example, a metal material having good heat conductivity may be used as the metal material of the refrigerant pipe 10. Specifically, for example, Cu, a Cu alloy, or the like may be used as the metal material of the refrigerant pipe 10.

The refrigerating apparatus (the air conditioner) 1 further has a composite pipe 22.

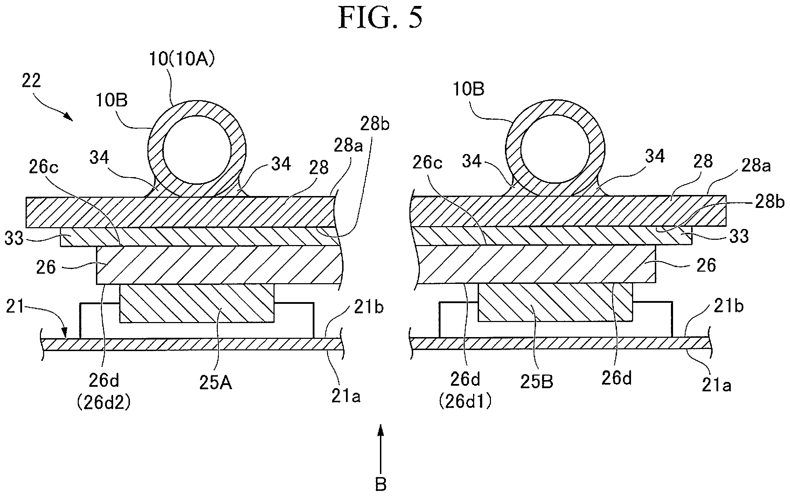

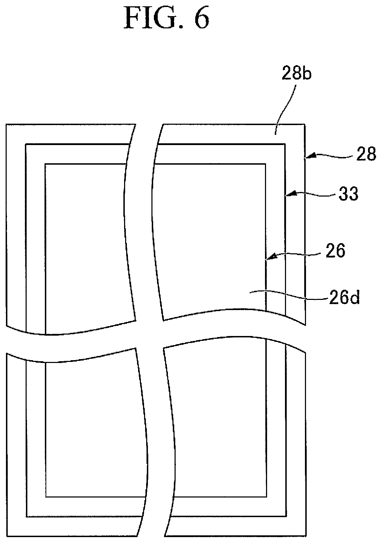

Here, the composite pipe 22 will be described with reference to FIGS. 2 to 6. In FIG. 5, the same components as in the structures shown in FIGS. 2 to 4 are designated by the same reference numerals. In FIG. 6, the same components as in the structure shown in FIG. 5 are designated by the same reference numerals.

The composite pipe 22 has the tubular sections 10B that are a part of the refrigerant pipe 10, a plate-shaped member 28, bonding sections 34, the cooling member 26 and a sheet-shaped heat transfer member 33.

The tubular section 10B is sandwiched between an inclined surface of a bracket 29 disposed below the plate-shaped member 28, protruding from the board accommodating section 14 toward the back face and substantially triangular when seen in a plan view and a clipping piece 30 facing the inclined surface at a predetermined position and in a predetermined direction.

The plate-shaped member 28 is formed of the same metal of the tubular section 10B. The plate-shaped member 28 has a first side plane 28a in contact with an outer circumferential surface of the tubular section 10B (the refrigerant pipe 10), and a second side plane 28b disposed opposite to the first side plane 28a. The second side plane 28b is in contact with the sheet-shaped heat transfer member 33.

The plate-shaped member 28 is inclined diagonally corresponding to the tubular sections 10B in a direction in which the pair of tubular sections 10B are arranged.

An outline of the plate-shaped member 28 can be configured to be larger than an outline of the cooling member 26 (see FIG. 6).

In addition, while a thickness of the plate-shaped member 28 is not particularly limited, for example, the thickness may be appropriately set within a range of 0.5 mm or more and 10 mm or less.

The bonding sections 34 are installed between the first side plane 28a of the plate-shaped member 28 and the outer circumferential surface of the tubular sections 10B. The bonding sections 34 are provided on both left and right sides perpendicular to an axial direction in a state in which the refrigerant pipe 10 is disposed along the plate-shaped member 28. In addition, the bonding sections 34 are continuously formed substantially throughout the length of facing portions of the refrigerant pipe 10 (the tubular section 10B) and the plate-shaped member 28.

The bonding section 34 is a member configured to join the plate-shaped member 28 to the tubular sections 10B. For example, an alloy (a brazing material) having a lower melting point than the welding section formed when a welding method is used, or the plate-shaped member 28 and the tubular sections 10B, may be used as the bonding sections 34.

Further, for example, when a Cu alloy is used as the metal material of the refrigerant pipe 10 and the plate-shaped member 28, the plate-shaped member 28 and the tubular sections 10B are preferably bonded using, for example, an alloy formed of a Cu alloy as the bonding sections 34.

The cooling member 26 has a first block 26a, the second block 26b, the block attachment/detachment screw 31 and a pipe attachment/detachment screw 32.

The first block 26a is formed diagonally with respect to the rear surface 21b of the circuit board 21 in the inclined direction of the plate-shaped member 28.

The first block 26a has a plane 26c that is one plane of the cooling member 26, and a surface 26e disposed opposite to the plane 26c.

The plane 26c is a plane in contact with the sheet-shaped heat transfer member 33. The surface 26e is a curved surface protruding from the plate-shaped member 28 toward the rear surface 21b of the circuit board 21.

In addition, a protrusion 26g protruding in the widthwise direction of the housing 23 is formed on the surface 26e. The protrusion 26g is formed at a position close to an end portion of the surface 26e separated from the circuit board 21.

Further, while the case in which the surface 26e is the curved surface has been exemplarily described as an example in FIG. 4, the surface 26e may be, for example, a plane, or may be a stepped shape when seen from above.

The second block 26b is installed on the first block 26a while coming in contact with the surface 26e. The second block 26b has a surface 26f in contact with the surface 26e, and a surface 26d disposed opposite to the surface 26f.

The surface 26f is a curved surface recessed to correspond to the curved shape of the surface 26e. Accordingly, the surface 26f comes in surface contact with the surface 26e. In addition, in a state in which the surface 26f and the surface 26e come in surface contact with each other, in end portions of the second block 26b, an end portion of a side separated from the circuit board 21 abuts the protrusion 26g.

The surface 26d is constituted by the two planes 26d1 and 26d2 that cross each other.

The plane 26d1 faces the rear surface 21b of the circuit board 21. The plane 26d2 faces the housing 23 in the widthwise direction. Accordingly, the planes 26d1 and 26d2 are disposed in a direction along the circuit board 21 and a direction standing upward from the circuit board 21.

The block attachment/detachment screw 31 is threadedly engaged with the second block 26b and the first block 26a such that a shaft section (not shown) reaches the first block 26a from the plane 26d1 side facing the attachment/detachment through-hole 27 formed in the circuit board 21.

A head section 31a of the block attachment/detachment screw 31 faces the attachment/detachment through-hole 27 to be exposed from the plane 26d1. The head section 31a of the block attachment/detachment screw 31 is configured to be smaller than the attachment/detachment through-hole 27 such that the head section 31a can pass through the attachment/detachment through-hole 27. Accordingly, the block attachment/detachment screw 31 can be operated from the front surface 21a side of the circuit board 21.

The cooling member 26 configured as described above cools the heat generating parts 25A and 25B using the cold of the refrigerant transmitted through the plate-shaped member 28.

An opening section 14a is installed on the board accommodating section 14. The heat generating parts 25A and 25B mounted on the rear surface 21b of the circuit board 21 protrude toward the back side of the board accommodating section 14 via the opening section 14a. The heat generating parts 25A and 25B are fixed to the surfaces 26d (specifically, the planes 26d1 and 26d2) by attachment screws or the like (not shown), respectively.

The sheet-shaped heat transfer member 33 is installed to be adhered to the second side plane 28b of the plate-shaped member 28 and the plane 26c of the cooling member 26 between the plate-shaped member 28 and the cooling member 26.

The sheet-shaped heat transfer member 33 transmits the cold of the refrigerant flowing through the tubular sections 10B to the cooling member 26 while suppressing a direct contact between the plate-shaped member 28 and the cooling member 26 formed of dissimilar metals.

In this way, since direct contact between the cooling member 26 and the refrigerant pipe 10 can be minimized by interposing the plate-shaped member 28 and the sheet-shaped heat transfer member 33 between the cooling member 26 and the refrigerant pipe 10 that are formed of a different metal from the refrigerant pipe 10 (the tubular section 10B), interface corrosion that occurs due to the contact between the cooling member 26 and the refrigerant pipe 10 formed of the dissimilar metals can be minimized.

In addition, since the direct contact between the plate-shaped member 28 and the cooling member 26 formed of the dissimilar metals can be minimized by interposing the sheet-shaped heat transfer member 33 between the plate-shaped member 28 and the cooling member 26 formed of the same metal as the refrigerant pipe 10, interface corrosion on an interface between the plate-shaped member 28 and the cooling member 26 can be minimized.

In addition, since the sheet-shaped heat transfer member 33 is adhered to the two planes (the plane 26c and the second side plane 28b), adhesiveness between the plate-shaped member 28, the cooling member 26 and the sheet-shaped heat transfer member 33 can be improved. Accordingly, interface corrosion due to the contact between the cooling member 26 and the refrigerant pipe 10 can be further suppressed.

For example, a heat conductive sheet such as a heat conductive viscous sheet, a heat conductive adhesive sheet, a heat conductive rubber, or the like, a heat conductive phase change sheet, and so on may be used as the sheet-shaped heat transfer member 33. For example, the heat conductive silicone rubber may be used as the heat conductive rubber, or a rubber other than the heat conductive silicone rubber may be used as the heat conductive rubber.

For example, the heat conductive sheet or the heat conductive phase change sheet is preferably used as the sheet-shaped heat transfer member 33. In particular, since the heat conductive phase change sheet is softened by heat, heat conductivity between the plate-shaped member 28 and the cooling member 26 can be increased.

In addition, since the heat conductive sheet or the heat conductive phase change sheet is used, occurrence of thickness non-uniformity that occurs when a silicone grease is used can be minimized.

As shown in FIG. 6, in a case where the outline of the plane 26c of the cooling member 26 is smaller than the outline of the second side plane 28b of the plate-shaped member 28, the sheet-shaped heat transfer member 33 is preferably formed such that a circumferential edge of the sheet-shaped heat transfer member 33 extends beyond the outline of the plane 26c of the cooling member 26.

In this case, since the sheet-shaped heat transfer member 33 is formed such that a circumferential edge of the sheet-shaped heat transfer member 33 extends beyond the outline of the plane 26c of the cooling member 26, direct contact between the cooling member 26 and the refrigerant pipe 10 can be minimized.

In addition, since the sheet-shaped heat transfer member 33 is adhered to the planes (the second side plane 28b of the plate-shaped member 28 and the plane 26c of the cooling member 26), an adhesive force between the second side plane 28b of the plate-shaped member 28, the plane 26c of the cooling member 26 and the sheet-shaped heat transfer member 33 can be sufficiently secured even when front surface roughness Ra of the second side plane 28b of the plate-shaped member 28 and the plane 26c of the cooling member 26 is high.

Accordingly, since high processing accuracy of front surfaces of the second side plane 28b of the plate-shaped member 28 and the plane 26c of the cooling member 26 is not required when the front surfaces are processed, processing cost of the composite pipe 22 can be reduced.

According to the composite pipe 22 of the embodiment, since direct contact between the cooling member 26 and the refrigerant pipe 10 can be minimized by interposing the plate-shaped member 28 and the sheet-shaped heat transfer member 33 between the cooling member 26 and the refrigerant pipe 10 that are formed of a different metal from the refrigerant pipe 10 (the tubular section 10B), interface corrosion that occurs due to the contact between the cooling member 26 and the refrigerant pipe 10 that are formed of dissimilar metals can be minimized.

In addition, since the sheet-shaped heat transfer member 33 is interposed between the plate-shaped member 28 and the cooling member 26 that are formed of the same metal as the refrigerant pipe 10, interface corrosion on the interface between the plate-shaped member 28 and the cooling member 26 can be minimized.

In addition, since adhesiveness between the plate-shaped member 28, the cooling member 26 and the sheet-shaped heat transfer member can be improved by attaching the two planes (the plane 26c and the second side plane 28b) to the sheet-shaped heat transfer member 33, interface corrosion due to the contact between the cooling member 26 and the refrigerant pipe 10 can be further minimized.

In addition, according to the refrigerating apparatus 1 including the composite pipe 22, the heat generating parts 25A and 25B can be sufficiently cooled while minimizing interface corrosion due to the contact between the cooling member 26 and the refrigerant pipe 10.

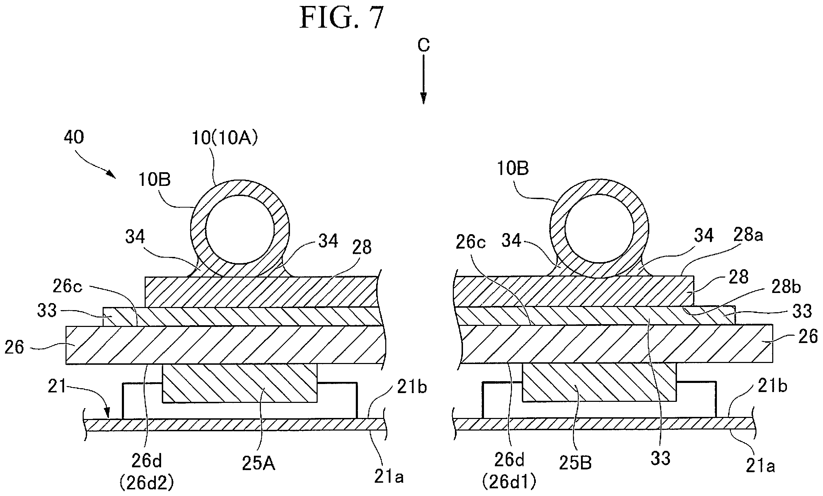

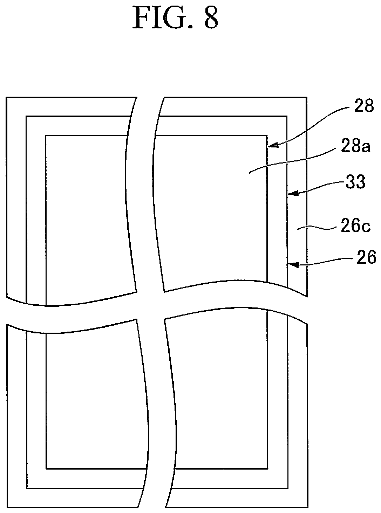

Next, a composite pipe 40 according to a variant of the embodiment will be described with reference to FIGS. 7 and 8. In FIG. 7, the same components as in the structure shown in FIG. 5 are designated by the same reference numerals. In FIG. 8, the same components as in the structure shown in FIG. 7 are designated by the same reference numerals.

The composite pipe 40 is configured similarly to the composite pipe 22 as described above except that the outline of the second side plane 28b of the plate-shaped member 28 is smaller than the outline of the plane 26c of the cooling member 26, and the sheet-shaped heat transfer member 33 is formed such that a circumferential edge of the sheet-shaped heat transfer member 33 extends beyond the outline of the second side plane 28b of the plate-shaped member 28.

The composite pipe 40 having the above-mentioned configuration can obtain the same effect as the composite pipe 22 described as above.

While a preferred embodiment of the present invention has been described above in detail, the present invention is not limited to the specific embodiment and various modifications and changes may be made without departing from the scope of the following claims.

For example, the area of the refrigerant pipe 10 disposed to come in contact with the cooling member 26 is not limited to the area 10A between the electronic expansion valve 6 and the indoor heat exchanger 8.

The area of the refrigerant pipe 10 disposed to come in contact with the cooling member 26 may be, for example, another area of the refrigerant pipe 10 that can cool the heat generating parts 25A and 25B installed on the controller 12. Specifically, for example, the area may be an area between the electronic expansion valve 6 and the outdoor heat exchanger 5. That is, the composite pipe 22 can be applied to various areas in the refrigerating cycle 11.

In addition, while the air conditioner has been exemplarily described as an example of the refrigerating apparatus 1 in the embodiment, the configuration of the refrigerating apparatus 1 may be applied to another refrigerating apparatus including a refrigerating cycle.

While a preferred embodiment of the invention has been described and illustrated above, it should be understood that this is exemplary of the invention and is not to be considered as limiting. Additions, omissions, substitutions, and other modifications can be made without departing from the scope of the present invention. Accordingly, the invention is not to be considered as being limited by the foregoing description, and is only limited by the scope of the appended claims.

### EXPLANATION OF REFERENCES

1 Refrigerating apparatus
2 Compressor
3 Four-way switching valve
4 Outdoor fan
5 Outdoor heat exchanger
6 Electronic expansion valve
7 Indoor fan
8 Indoor heat exchanger
9 Accumulator
10 Refrigerant pipe
21 Circuit board
22, 40 Composite pipe
25A, 25B Heat generating parts
26 Cooling member
28 Plate-shaped member
33 Sheet-shaped heat transfer member
34 Bonding section

## Claims

1. A composite pipe (22;40) for a refrigerating apparatus comprising:
a refrigerant pipe (10) formed of a metal and through which a refrigerant is allowed to flow;
a plate-shaped member (28) formed of the same metal of the refrigerant pipe (10) and having a first side plane (28a) in contact with an outer circumferential surface of the refrigerant pipe (10) and a second side plane (28b) opposite to the first side plane (28a);
a bonding section (34) installed between the first side plane (28a) of the plate-shaped member (28) and the outer circumferential surface of the refrigerant pipe (10) so as to join the refrigerant pipe (10) with the plate-shaped member (28);
a cooling member (26) configured to cool heat generating parts (25A,25B) via the plate-shaped member (28) by the refrigerant flowing through the refrigerant pipe (10), which is formed of a different metal from the refrigerant pipe (10) and the plate-shaped member (28), and has a first surface (26c) facing the second side plane (28b) of the plate-shaped member (28) and a second surface (26d) opposite to the first surface (26c) and in contact with the heat generating parts (25A,25B); and
a sheet-shaped heat transfer member (33) installed between the plate-shaped member (28) and the cooling member (26) so as to be adhered to the second side plane (28b) of the plate-shaped member (28) and the first surface (26c) of the cooling member (26).

2. The composite pipe (22;40) according to claim 1, wherein the sheet-shaped heat transfer member (33) is a heat conductive sheet or a heat conductive phase change sheet.

3. The composite pipe (22;40) according to claim 1 or 2, wherein an outline of one of the second side plane (28b) of the plate-shaped member (28) and the first surface (26c) of the cooling member (26) is smaller than that of the other, and
the sheet-shaped heat transfer member (33) is in contact with the one of the second side plane (28b) of the plate-shaped member (28) and the first surface (26c) of the cooling member (26) such that a circumferential edge of the sheet-shaped heat transfer member (33) extends beyond the outline of the one.

4. A refrigerating apparatus (1) comprising:
the composite pipe (22;40) according to any one of claims 1 to 3; and
a circuit board (21) provided with a circuit board main body whose circuit pattern is formed on one surface of the circuit main body and the heat generating parts (25A,25B) being mounted on the circuit pattern, wherein the heat generating parts (25A,25B) are in contact with the second surface (26d) of the cooling member (26).

## Patentansprüche

1. Verbundrohr (22;40) für eine Kältevorrichtung, das Folgendes umfasst:
ein Kältemittelrohr (10), das aus einem Metall gebildet ist und durch das ein Kältemittel strömen kann;
ein plattenförmiges Element (28), das aus demselben Metall des Kältemittelrohrs (10) gebildet ist und eine erste Seitenebene (28a) in Kontakt mit einer Außenumfangsfläche des Kältemittelrohrs (10) und eine zweite Seitenebene (28b) gegenüber der ersten Seitenebene (28a) aufweist;
einen Bondingbereich (34), der zwischen der ersten Seitenebene (28a) des plattenförmigen Elements (28) und der Außenumfangsfläche des Kältemittelrohrs (10) installiert ist, um das Kältemittelrohr (10) mit dem plattenförmigen Element (28) zu verbinden;
ein Kühlelement (26), das dazu ausgelegt ist, wärmeerzeugende Teile (25A,25B) via das plattenförmige Element (28) mittels des Kältemittels, das durch das Kältemittelrohr (10) strömt, zu kühlen, aus einem anderen Metall als das Kältemittelrohr (10) und das plattenförmige Element (28) gebildet ist und eine erste Fläche (26c), die der zweiten Seitenebene (28b) des plattenförmigen Elements (28) zugewandt ist, und eine zweite Fläche (26d) gegenüber der ersten Fläche (26c) und in Kontakt mit den wärmeerzeugenden Teilen (25A,25B) aufweist; und
ein blattförmiges Wärmeübertragungselement (33), das zwischen dem plattenförmigen Element (28) und dem Kühlelement (26) installiert ist, um an die zweite Seitenebene (28b) des plattenförmigen Elements (28) und die zweite Fläche (26c) des Kühlelements (26) geklebt zu sein.

2. Verbundrohr (22;40) nach Anspruch 1, wobei das blattförmige Wärmeübertragungselement (33) ein wärmeleitfähiges Blatt oder ein wärmeleitfähiges Phasenwechselblatt ist.

3. Verbundrohr (22;40) nach Anspruch 1 oder 2, wobei ein Umriss von einem der zweiten Seitenebene (28b) des plattenförmigen Elements (28) und der ersten Fläche (26c) des Kühlelements (26) kleiner ist als der des anderen, und
das blattförmige Wärmeübertragungselement (33) ist mit dem einen der zweiten Seitenebene (28b) des plattenförmigen Elements (28) und der ersten Fläche (26c) des Kühlelements (26) in Kontakt, derart, dass sich eine Umfangskante des blattförmigen Wärmeübertragungselements (33) über den Umriss des einen hinaus erstreckt.

4. Kältevorrichtung (1), die Folgendes umfasst:
das Verbundrohr (22;40) nach einem der Ansprüche 1 bis 3; und
eine Leiterplatte (21), die mit einem Leiterplattenhauptkörper versehen ist und deren Schaltungsmuster auf einer Fläche des Schaltungshauptkörpers gebildet ist, und wobei die wärmeerzeugenden Teile (25A,25B) auf dem Schaltungsmuster montiert sind, wobei die wärmeerzeugenden Teile (25A,25B) mit der zweiten Fläche (26d) des Kühlelements (26) in Kontakt sind.

## Revendications

1. Tuyau composite (22 ;40) pour un appareil réfrigérant comprenant :
un tuyau de réfrigérant (10) formé à partir d'un métal et à travers lequel un réfrigérant est autorisé à s'écouler ;
un élément en forme de plaque (28) formé avec le même métal que le tuyau de réfrigérant (10) et ayant un premier plan latéral (28a) en contact avec une surface circonférentielle externe du tuyau de réfrigérant (10) et un second plan latéral (28b) opposé au premier plan latéral (28a) ;
une section de liaison (34) installée entre le premier plan latéral (28a) de l'élément en forme de plaque (28) et la surface circonférentielle externe du tuyau de réfrigérant (10) afin d'assembler le tuyau de réfrigérant (10) avec l'élément en forme de plaque (28) ;
un élément de refroidissement (26) configuré pour refroidir des parties de génération de chaleur (25A,25B) via l'élément en forme de plaque (28) par le réfrigérant qui s'écoule à travers le tuyau de réfrigérant (10), qui est formé avec un métal différent du tuyau de réfrigérant (10) et de l'élément en forme de plaque (28), et a une première surface (26c) faisant face au second plan latéral (28b) de l'élément en forme de plaque (28) et une seconde surface (26d) opposée à la première surface (26c) et en contact avec les parties de génération de chaleur (25A,25B) ; et
un élément de transfert de chaleur en forme de feuille (33) installé entre l'élément en forme de plaque (28) et l'élément de refroidissement (26) afin d'être fixé au second plan latéral (28b) de l'élément en forme de plaque (28) et la première surface (26c) de l'élément de refroidissement (26).

2. Tuyau composite (22 ;40) selon la revendication 1, dans lequel l'élément de transfert de chaleur en forme de feuille (33) est une feuille thermo-conductrice ou une feuille thermo-conductrice à changement de phase.

3. Tuyau composite (22 ;40) selon la revendication 1 ou 2, dans lequel un contour de l'un parmi le second plan latéral (28b) de l'élément en forme de plaque (28) et la première surface (26c) de l'élément de refroidissement (26) est inférieur par rapport à celui de l'autre, et
l'élément de transfert de chaleur en forme de feuille (33) est en contact avec l'un parmi le second plan latéral (28b) de l'élément en forme de plaque (28) et la première surface (26c) de l'élément de refroidissement (26) de sorte qu'un bord circonférentiel de l'élément de transfert de chaleur en forme de feuille (33) s'étend au-delà du contour du premier.

4. Appareil réfrigérant (1) comprenant :
le tuyau composite (22 ;40) selon l'une quelconque des revendications 1 à 3 ; et
une carte de circuit imprimé (21) prévue dans un corps principal de carte de circuit imprimé dont le motif de circuit est formé sur une surface du corps principal de circuit et les parties de génération de chaleur (25A,25B) étant montées sur le motif de circuit, dans lequel les parties de génération de chaleur (25A,25B) sont en contact avec la seconde surface (26d) de l'élément de refroidissement (26).
